## Europäisches Patentamt
## European Patent Office
## Office européen des brevets

(19)

(11) Publication number: **0 010 971**
**B1**

(12) **EUROPEAN PATENT SPECIFICATION**

(45) Date of publication of patent specification: **21.03.84**

(51) Int. Cl.³: **C 23 C 13/02**

(21) Application number: **79302415.9**

(22) Date of filing: **02.11.79**

(54) Deposition process.

(30) Priority: **02.11.78 US 957373**
**02.11.78 US 957374**
**09.07.79 US 55939**

(43) Date of publication of application:
**14.05.80 Bulletin 80/10**

(45) Publication of the grant of the patent:
**21.03.84 Bulletin 84/12**

(84) Designated Contracting States:
**DE FR GB**

(56) References cited:
**DE - A - 2 449 542**
**DE - B - 1 225 939**
**FR - A - 1 107 514**
**FR - A - 1 424 767**
**US - A - 3 615 881**
**US - A - 3 856 647**

**ELECTRONICS LETTERS, vol. 2, no. 8, August 1966, pages 292-293, S. DEMBICKA-JELLONKOWA: "Effect of Glow Discharge on Chromium Thin-Film Resistance"**

(73) Proprietor: FORD MOTOR COMPANY LIMITED
Eagle Way
Brentwood Essex CM13 3BW (GB)
(84) GB
(73) Proprietor: FORD-WERKE AKTIENGESELLSCHAFT
Ottoplatz 2 Postfach 21 03 69
D-5000 Köln 21 (DE)
(84) DE
(73) Proprietor: FORD FRANCE SOCIETE ANONYME
344 Avenue Napoléon Bonaparte B.P. 307
F-92506 Rueil Malmaison Cedex (FR)
(84) FR

(72) Inventor: Gaerttner, Martin Rudolf
2601 Detroit Street
Dearborn, Michigan 48124 (US)
Inventor: Hoffman, David Wyeth
19265 Addison
Southfield, Michigan 48075 (US)

(74) Representative: Drakeford, Robert William et al,
Ford Motor Company Limited 15/448, Research & Engineering Centre Laindon
Basildon Essex SS15 6EE (GB)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

(56) References cited:

IBM TECHNICAL DISCLOSURE BULLETIN, vol. 19, no. 9, February 1977, page 3631, J.J. DEMPSEY et al.: "Low Stress Chromium Film"

JOURNAL OF THE ELECTROCHEMICAL SOCIETY, vol. 115, no. 8, 1968, pages 823-826, E. KLOKHOLM et al.: "Intrinsic Stress in Evaporated Metal Films"

Deposition process

This invention relates to deposition processes.

Vacuum deposition is a well known process, and various modifications of the process are described in the following documents:—

U.S. Patent No. 3,528,387 discloses an apparatus for substrate modification including cleaning that employs evaporant and ion sources. U.S. Patents Nos. 3,904,505 and 3,961,103 disclose apparatus and process that, in one embodiment, employ together evaporant and ion sources for deposition. The article "Physics of Ion Plating and Ion Beam Deposition" by Aisenberg (inventor of U.S. '505 and '103 above) et al, J. Vac. Sci., Vol. 10, No. 1, Jan. 1 Feb., 1973 pp. 104—107 discloses concurrent use of evaporant and ion sources for deposition.

The article "The Compressive Stress Transition in Al, V, Zr, Nb and W Metal Films Sputtered at Low Working Pressures," by Hoffman (an inventor herein) and Thornton in THIN SOLID FILMS 45 (1977) 387—396 discloses stress alteration through sputtering at low pressures using magetron plasma confinement and also discloses that bias sputtering can alter deposit stress.

The article "Stress in Ion-Implanted CVD $Si_3N_4$ Films" by EarNisse in JOURNAL OF APPLIED PHYSICS, Vol. 48, No. 8, August 1977 discloses stress alteration in CVD deposits of $Si_3N_4$ insulators on silicon using ion bombardment.

Although vapour deposition and ion bombardment processes have been disclosed before, hitherto no-one has appreciated that these techniques can be used to improve the internal stress, and other properties, e.g. optical reflectance, of metal deposits.

According to the present invention, there is provided a deposition process which comprises depositing a metal on to a substrate from the vapour phase, and bombarding the deposit with energetic ions, characterised in that the bombardment alters the internal stress of the deposit to produce zero or a compressive stress therein, and is effected with from 0.1 to 30 ions per 100 atoms of deposit, the ions having energies of from 0.1 to 30 KeV.

The bombardment of material deposited by vacuum deposition e.g. by metallization from evaporant sources, enhances the deposition process. An advantageously low ratio of ions to other deposition particles yield, when the ions are sufficiently accelerated, deposits that have desirable internal stress. As few as 1 or 2 ions per 200 deposited particles may bring about desired change (e.g. diminish tensile stress, bring about compressive stress) and even smaller ratios can be employed, if desired.

In depositing a transition metal such as chromium vapour that normally deposits in tension, bombardment of its deposits by ions of, for example, inert gas can modify the metal deposit to have compressive stresses comparable in magnitude to tensile stresses that occur without bombardment.

This stress modification is preventative of cracking and peeling of the deposit from the substrate. Furthermore, with metal as chromium, bombardment that causes stress change in the deposit also can improve reflectance.

The ions may be of an inert gas or a metal. Preferably the ions are of the same element as that used for the deposition.

Since only a few energetic particles per otherwise deposited particle yield desirable modification, substrates such as heat resistance plastics may be used without their deformation, degradation and the like, even when relatively thick films, e.g., over 1000Å are deposited.

Preferably, an evaporant source is used in conjunction with a stress modifying level of ions that is below that which causes undesirable substrate heating so that high quality thin metal films can be deposited rapidly on heat sensitive materials. Plastics materials may therefore be used as the substrate.

The bombardment may be carried out during the deposition, or after the deposition.

A diverse group of materials are depositable from vapour in a vacuum and can be employed in accordance with this invention. As these materials or derivatives thereof constitute that which will comprise most, by weight, if not all, of the deposit on the substrate, they will for convenience, be called herein "primary deposition materials".

The primary deposition materials for which this invention is especially applicable are metals which normally form deposits that are in tension from vacuum operations such as by vapour deposition from evaporant sources. Refractory transition metals constitutes one such class of metals and suitable metal may be selected therefrom, particularly for example, for improved optical reflectance when deposition is otherwise with less than desired reflectance from evaporant sources. Thus, suitable metals may include any selected from the following as well as alloys (e.g. stainless steel) based on (or containing) one or more of the following: titanium, vanadium, chromium, iron, nickel, cobalt, molybdenum, platinum, palladium, rare earth as gadolinium, ruthenium, zirconium, rhodium, niobium, osmium, rhenium and other such metals that are of Groups IIIa—VIIa and VIII of the Periodic Table. Some non-refractory materials may also be used, e.g. aluminum 6061 alloy may also receive desired stress alteration when deposited from vapour.

Of transition metals, the first series transition metals such as chromium illustrate a particular value of this invention. Chromium, and its bright alloys, for example, normally deposit from evaporant sources in an undesirable off-colour and in tension that restrict use from evaporant sources. Other deposits besides those of the first series as chromium that similarly may derive benefit from this invention include niobium, molybdenum, tantalum and gadolinium and alloys based on any of such metals.

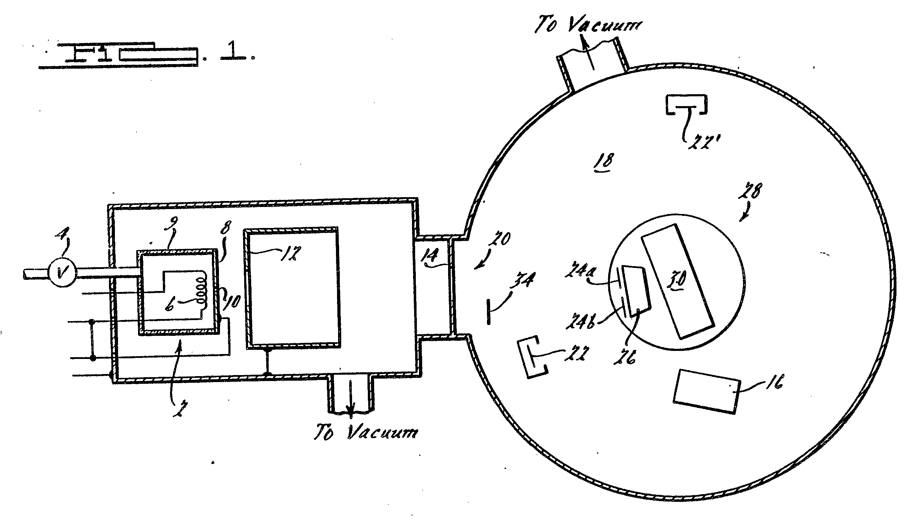

In a first embodiment, this invention comprises utilizing deposition from an evaporant source of primary deposition material, e.g., resistively, electron bombarded or otherwise heated source, in a vacuum chamber desirably maintained at levels below about 1.33 Pa ($10^{-2}$ Torr), especially below about $13.3 \times 10^{-3}$ Pa ($10^{-4}$ Torr), and as is illustrated in Figure 1. Although any source or sources of vapour or vapours of the primary deposition material including charged species thereof may be used, evaporant sources offer special advantage as to, for example, convenience, power efficiency and rapid deposition. The precise vacuum pressure during such deposition is not normally a critical feature of this invention. As is understood with any deposition process, however, partial pressure of interfering or deleterious substances (e.g., partial pressure of reactive oxygen during deposition of chromium) should be kept as low as possible. When vapours are inert or desirably included, they may be within the vacuum at varying vapour pressures differing from the above recited average pressures of the vacuum chamber (e.g. vapour pressure of primary deposition material at its source or at its deposition destination).

In this first embodiment, using an evaporant source, a substrate is placed in the vacuum so as to permit contact with the vapour and formation of a deposit on the substrate with the primary deposition material. The substrate may be of conducting or non-conducting material. This invention offers advantage in that heat sensitive substrates as plastics, e.g., those commonly known as "ABS", may be employed when depositing thin films. Advantageously, the substrate may be prepared for deposition by bombardment with energetic particles prior to any vapour deposition. Such prior bombardment can cause a sputtering off of surface contaminants and can provide a more adhering substrate surface.

The order in which the energetic particles bombard the vapour deposit is not critical. Rather, the flux of depositing vapour as well as the flux of energetic particles may be varied as desired. For example, the energetic particles may continuously or intermittently bombard the deposit as it is being built-up. Moreover, the energetic particles may bombard the deposit during a time when it is not being built-up or not being built-up as rapidly as during another time.

In one advantageous manner of still further mitigating substrate heating, if desired, the substrate or sources may be moved relative to one another thereby varying the amount of vapour and energetic particles contacting the substrate with time. Thus, for example, substrate that is to receive deposition of primary deposition material may be rotated, translated or otherwise moved between locations of high vapour flux and high energetic particle flux so as to disassociate, at least in part, heating effects due to each and permit intermediate cooling, if desired. For thick films, such sequential vapour deposition and energetic particle bombardment may advantageously use more than two sources of, or rotation or oscillation between, sources of vapour and energetic particles. Such sequence may be repeated many times, e.g. 100 or more.

One convenient approach is to use ions from separately actuated ion sources as ion guns which are conventionally known and commercially available. The ion guns can be external to the chamber wherein vapour deposition occurs and actuated as desired. Ions of inert gas, e.g., krypton, argon, xenon, or primary deposition material, e.g., chromium or even neutral particles or beams, e.g., mixed ions and electrons, or other atoms as nitrogen, may be employed.

At any given energy level in this or other embodiments, a certain amount of experimentation may be required to determine the relative number of ions per particles of primary deposition material for any particular substrate employed in order that the deposit advantageously have desired stress and other physical properties. The final chosen number of ions at any given energy for industrial processes may also depend on secondary factors such as power consumption, deposition and bombardment rate, nature of primary deposition material, bombarding species, substrate material including its capacity to withstand heat, film thickness required and the like. Unless the minimum number for each energy level of bombarding ions per otherwise depositing particles is reached, however, for desired stress change, no significant effect is seen. As before, this minimum number is advantageously low.

It is important, however, that not too high a number of ions at a given energy level be used that would lead to undesired sputtering of the deposited primary deposition material after its deposition. Such sputtering can cause erosion of the deposit surface as well as possible other degradation of film character.

Thus, for example, in concurrent bombardment and vapour deposition processes, upon establishment of the dose of ions at a given energy level that alters stress from tension to compression and provides desirable reflectance, the number of ions should desirably not exceed say be a factor of 20, preferably, a factor of 10 or less, the number of energetic particles that is critical to achieve change from tension to compression.

While experimentation may, as above suggested, be useful for optimal levels of energetic particles, a range of up to about 30 or even less, e.g., about 0.1—5, ions as inert gas ions and the like at about 0.1—30 KeV, per 100 deposited particles of primary deposition material such as chromium and its bright alloys, when using an evaporant source of such primary deposition material and separately activated ion gun, is normally sufficient on non-conducting substrates. Higher ratios of ions per otherwise depositing particles may be advantageous if the energetic particles are ions or atoms of the same type as the primary deposition material, especially when at the lower of the recited energies. When higher energy energetic particles are used, lower ratios of ions are required to produce the desired effect.

The measurement of internal stresses of deposits can be accomplished by any convenient method as, for example, those reported by D.S. Campbell in "Handbook of Thin Film Technology" Maissel and Glang, eds. p. 21—1, McGraw-Hill. For metals as chromium, a simple comparison (with the eye) is normally adequate to distinguish between (a) deposition as from an evaporant source and (b) deposition modified by energetic particles. This is because chromium and its bright alloys show correlation between reflective brightness and deposition in compression.

A particular advantage of the method of this invention is that no external biasing of the substrate need be made. Rather, the source of ions may be separately actuated at desired levels and directed or otherwise allowed to contact the substrate with deposits of primary deposition material thereon. This separate actuation allows for use of several sources of energetic particles of varying types concurrently or sequentially, if desired, and precise control of film quality, especially on curved substrates.

It is not altogether clear from present evidence whether or not it is the kinetic energy or momentum of the ions that is fundamentally related to stress modification of deposited films. Knowledge of the precise relationship is not however, necessary for practice of the invention as the ending stress characteristics can be readily controlled by controlling the amount of energetic particles at any given energy level.

An advantageous aspect of this invention is that thick films, e.g., above about 1000Å thick, as for instance, 2000Å—20,000Å or more of chromium or its alloys or other decorative metals on heat resistant or cooled plastic substrate may be deposited. Such thick films can be accomplished, for example, as follows.

Chromium or bright alloy is evaporated into a chamber maintained at pressures in a range below about one millitorr whereupon deposition begins on the plastic substrate in the vacuum. A source of, for example, ions of inert gas, or ions of chromium are introduced into the vacuum to contact chromium deposit as it is being deposited from the evaporant source. The ions required to produce compressive stress increases are desirably at about 0.5—15 Kev or more and the number of ions at these energy levels lies between about 0.2—20 per 100 evaporant atoms of chromium or bright alloy that are in the deposit. The bombarding of the deposits of vapour by the ions is continued until the ending deposit is a thick film as above described and has its stress characteristics showing deposition stress about zero or slightly or even greater in compression as desired for a particular application. Alternatively, the contacting with the ions may be intermittent (e.g. after a 1—4×10⁻⁷ m (1—4000Å) thick film has been vapour deposited) with similar results.

During the period of deposition no external bias, as previously mentioned, need be applied to the substrate, although, such external bias may, if desired, be applied.

The following examples are provided to illustrate certain aspects of this invention as previously described and is not intended as limiting the scope of this invention. In the examples, reference is made to the accompanying drawings, in which:—

Figure 1 illustrates schematically an apparatus adapted for use in this invention with separate ion source and evaporative source.

Figure 2 illustrates graphically results of Example 1 by showing stress change along with reflectance change for chromium deposits that are bombarded with varying numbers and energy levels of ions.

Figure 3 illustrates graphically results of Example 2 and shows effect of substrate temperature on stress of deposited film.

Figure 4 illustrates schematically another apparatus for use in this invention with separate ion and evaporative sources.

Example 1

Figure 1 illustrates in schematic fashion an arrangement of apparatus that may be used to deposit films in accordance with this invention.

In this apparatus, a Colutron ion source 2 is used to produce energetic ions. The gas to be ionized enters the chamber of the source 2 through a needle valve 4 which adjusts flow so that the gas pressure within the chamber 2 is in the 0.6—133 Pa (5 to 100 millitorr) range. The pressure within the rest of the vacuum system is kept below 166×10⁻⁴ Pa (2×10⁻⁴ torr) to prevent undesirable loss of ion beam current and to prevent incorporation of impurity gas atoms within the films being grown.

An arc is established between a resistively heated filament 6 (partially surrounded by ceramic insulator 9) and an anode 8 of the ion source, providing a dense plasma in the vicinity of the filament and anode. Ions are extracted from this plasma through an aperture 10 in the ion source and accelerated to a desired energy, (e.g. 1 to 15 Kev) by applying a positive voltage on the ion source relative to the grounded extraction lens 12. The ions drift through the extraction lens and through other ion optics (not shown, but located between extraction lens 12 and aperture 20) into the chamber of the vacuum system 18. An aperture 20 is used to limit the extent of the ion beam within the chamber.

A resistively heated source 22 (power supply not shown) provides a controlled rate of deposition of, for example, chromium onto a pair of substrates 24a and 24b on substrate holder 26 mounted on a rotatable carousel 28 (the rotary vacuum feedthrough and mechanical linkage is not shown). By rotating the carousel the ion beam may strike either or both of the substrates. An ion collector 30 may be rotated into proper orientation to monitor the ion beam current. By measuring this current, which is usually kept constant in this example, the flux of ion bombardment upon a substrate may be determined. Device 16 is a quartz crystal film monitor.

The ion beam collides with one of the substrates 24a while at the same time chromium is being evaporated onto the pair of substrates. The second substrate 24b accumulates approximately the same chromium deposit as substrate 24a; however, for comparison purposes substrate 24b is not bombarded with ions. A movable shutter 34 (mechanical linkage not shown) permits control of which substrate is bombarded with ions.

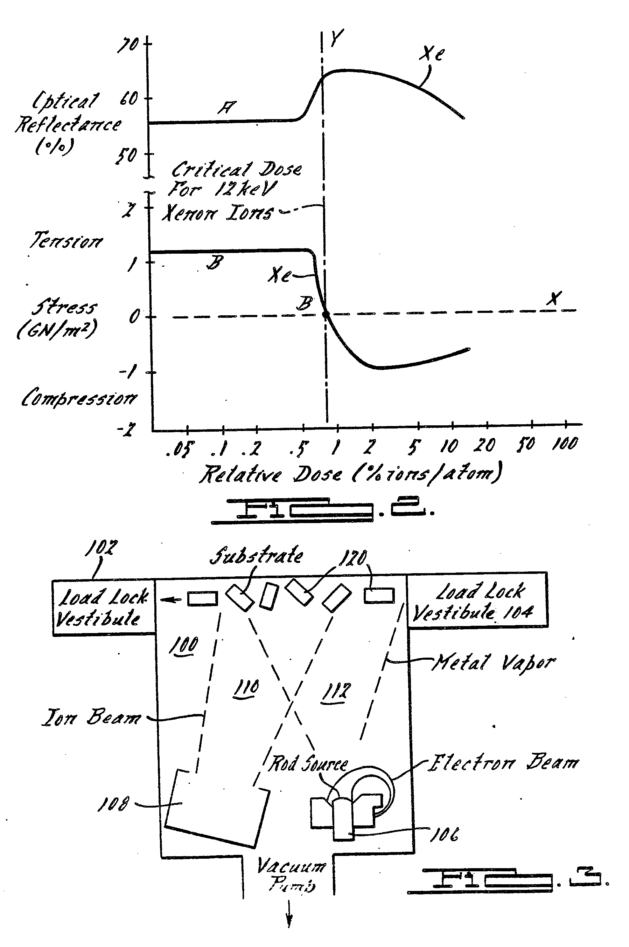

Figure 2 illustrates graphically the results of deposition of chromium on glass (rate of about $3 \times 10^{-10}$ m/second (3Å/second)) using the above described apparatus in accordance with the invention. The X axis is per cent of ions bombarding the vapour deposited metal on the substrate. The Y axis is optical reflectance for curve A and stress for curve B.

From curve A it may be seen that reflectance is beneficially altered by certain doses of 12 Kev ions of xenon. From curve B it can be seen that stress is also altered by certain dose of xenon, energetic ions at 12 Kev.

By comparing curves A and B, it can be seen that optical brightness also correlates with deposition of film in compression at the same ratios of energetic particles at the same energy level.

The film thicknesses of chromium in this Example are approximately $2 \times 10^{-7}$ m (2000Å). The absolute dose in Figure 2 is uncertain and the critical dose could be 1/3 less than the 0.9% indicated. The dose is relative in Figure 2 and the purpose of this Figure 2 is to illustrate optical reflectivity change of the same dose at which stress becomes compressive.

Example 2

Using the procedures of Example 1, bombardment is with argon ions rather than xenon ions. Also, the temperatures of the substrates bombarded are monitored and controlled. Temperature control (60°C) of substrates bombarded is with heat sink to a massive copper block using liquid gallium—indium eutectic. "Hot substrates" are glass allowed to warm up to combined power input to the substrates (e.g. from radiation, ion beam current, and chromium condensation). It is estimated that the "hot substrate" temperature exceeds 200°C.

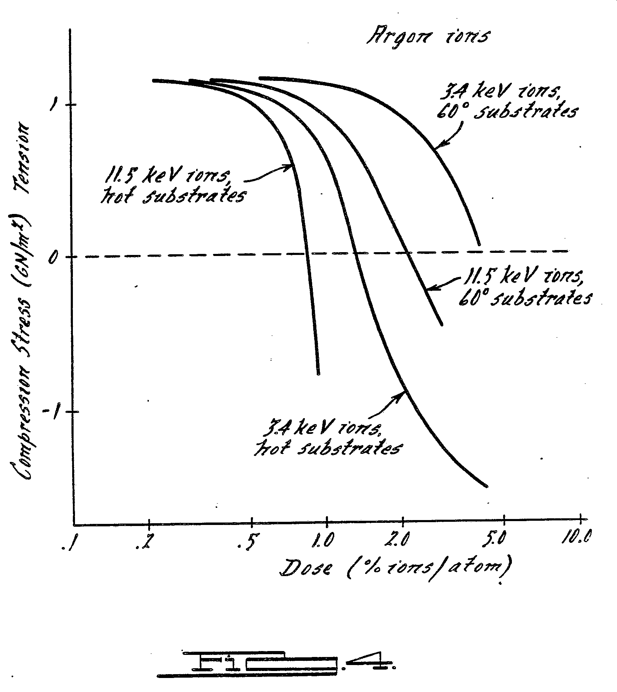

Figure 4 shows results of dose (ions per 100 deposited atoms) versus internal stress of chromium films at the different temperatures. The results are shown with smooth curves which are estimated from data points that are not greater than ±25% from the curve. Stress is determined as noted above.

Example 3

The ions of xenon at 12 Kev of Example 1 are replaced by ions of chromium and the procedures of Example 1 using the apparatus of Figure 1 are repeated with similar results.

Example 4

The procedures of Example 1 are again followed with respect to ion-modified deposition using the apparatus of Figure 1 except that the vapour deposition and ion bombardment are conducted sequentially by permitting a buildup of $2 \times 10^{-8}$ m (200Å) layers of chromium before beginning bombarding with the ions of inert gas. The percent of ions bombarding the $2 \times 10^{-8}$ m (200Å) layers of chromium is varied in accordance with Figure 2. The results show similarly desirably improved stress and reflectance at critical doses.

Example 5

The procedures of Example 1 are followed except that alternative evaporative source 22' is employed rather than source 22 and the movable shutter 34 is not used. Carousel 28 is filled with several spaced substrates and is rotated to provide alternating vapour deposition and ion bombardment for the substrates as it rotated. Desirable stress and brightness are seen with chromium deposition modified by argon ions at 12 Kev.

Example 6

Figure 3 illustrates a coating apparatus for deposition onto a large area at high rates on stationary or moving (translated and/or rotating) substrates or parts. The components shown are:

1. Industrial-sized diffusion pumped vacuum chamber 100 with capability for pressure maintenance at or below 0.13 Pa ($10^{-3}$ torr); provision for continuous or semicontinuous introduction and removal of workpieces to be coated by means of separately pumped vestibules 102 and 104 and vacuum gate valves (not shown); fixturing (not shown) for translation and/or rotation of workpieces 120 through the chamber.

2. High-rate electron beam heated evaporator 106 with continuous introduction of evaporant 112 by rod feed that has evaporation capacity on the order of 0.1—10 cm³ of metal per minute per source.

3. Ion beam source 108 of ion-milling type (large area, high current density, neutralized beam) that provides 0.5 milliamp/cm² of ionized argon 110 over 30 centimeter diameter. (Apparatus can employ multiple evaporation and ion sources to cover enlarged areas as desired). Operating parameters are adjusted to obtain high rate deposition with sufficient dose of accelerated ions to produce compressive-bright films accordingly as in Example 1 and as hereinbefore described. Owing to the sharp-transition nature of the phenomenon (see Fig. 2) it is not necessary that the ion dose be everywhere uniform, but only that it exceed (but desirably not by more than a factor of 15) the minimum required dosage, as determined in specific application by examination of film quality.

## Claims

1. A deposition process which comprises depositing a metal on to a substrate from the vapour phase, and bombarding the deposit with energetic ions, characterised in that the bombardment alters the internal stress of the deposit to produce zero or a compressive stress therein, and is effected with from 0.1 to 30 ions per 100 atoms of deposit, the ions having energies of from 0.1 to 30 KeV.

2. A process according to Claim 1 wherein the metal comprises a transition metal.

3. A process according to Claim 1 wherein the metal comprises chromium or an alloy thereof.

4. A process according to any one of Claims 1 to 3 wherein the bombardment is effected whilst the metal is being deposited.

5. A process according to any one of Claims 1 to 3 wherein the bombardment is effected after the deposition.

6. A process according to Claim 5 wherein the deposition and the bombardments are carried out by causing relative movement between the substrate and a first location containing the metal at a high vapour density, and a second location containing the energetic ions whereby the substrate is sequentially exposed to the high vapour density and the energetic ions.

7. A process according to Claim 6 wherein the substrate is advanced through the first and second locations.

8. A process according to any one of Claims 1 to 7 wherein the substrate comprises a plastics material.

9. A process according to any one of Claims 1 to 8 wherein the ions are of an inert gas.

10. A process according to any one of Claims 1 to 9 wherein the ions are of a transition metal.

11. A process according to Claim 10 wherein the ions are of chromium.

12. A process according to any one of Claims 1 to 11, wherein the metal is one which tends to form a deposit in tension.

13. A process according to any one of Claims 1 to 12 wherein the deposit is in compression after bombardment.

## Patentansprüche

1. Beschichtungsverfahren, umfassend die Aufdampfung eines Metalls auf ein Substrat und das Beschiessen der Beschichtung mit energiereichen Ionen, dadurch gekennzeichnet, dass die Beschiessung die innere Spannung in der Beschichtung ändert, um jene auf null zu bringen oder darin eine Druckspannung zu erzeugen, und mit 0,1 bis 30 Ionen auf 100 Beschichtungsatome durchgeführt wird, wobei die Ionen Energien von 0,1 bis 30 KeV besitzen.

2. Verfahren nach Anspruch 1, worin das Metall aus einem Uebergangsmetall besteht.

3. Verfahren nach Anspruch 1, worin das Metall aus Chrom oder einer Chromlegierung besteht.

4. Verfahren nach einem der Ansprüche 1 bis 3, worin die Beschiessung während der Beschichtung mit Metall erfolgt.

5. Verfahren nach einem der Ansprüche 1 bis 3, worin die Beschiessung nach der Beschichtung erfolgt.

6. Verfahren nach Anspruch 5, worin die Beschichtung und die Beschiessungen dadurch erfolgen, dass man eine Relativbewegung zwischen dem Substrat und einer ersten, eine hohe Metalldampfdichte enthaltenden Stelle sowie einer zweiten, die energiereichen Ionen enthaltenden Stelle bewirkt, wodurch das Substrat nacheinander der hohen Dampfdichte und den energiereichen Ionen ausgesetzt wird.

7. Verfahren nach Anspruch 6, worin das Substrat durch die ersten und zweiten Stellen vorgeschoben wird.

8. Verfahren nach einem der Ansprüche 1 bis 7, worin das Substrat aus einem Kunststoff besteht.

9. Verfahren nach einem der Ansprüche 1 bis 8, worin die Ionen Inertgasionen sind.

10. Verfahren nach einem der Ansprüche 1 bis 8, worin die Ionen Uebergangsmetallionen sind.

11. Verfahren nach Anspruch 10, worin die Ionen Chromionen sind.

12. Verfahren nach einem der Ansprüche 1 bis 11, worin das Metall ein solches ist, das zur Bildung einer Beschichtung unter Spannung neigt.

13. Verfahren nach einem der Ansprüche 1 bis 12, worin die Beschichtung nach der Beschiessung auf Druck beansprucht ist.

## Revendications

1. Procédé de dépôt consistant à déposer un métal sur un substrat à partir de la phase vapeur, puis bombarder le dépôt avec des ions énergétiques, caractérisé en ce que le bombardement modifie la tension interne du dépôt pour y créer une tension nulle ou une tension de compression, ce bombardement étant effectué avec 0,1 à 30 ions pour 100 atomes de dépôt, les ions ayant des énergies se situant entre 0,1 et 30 KeV.

2. Procédé suivant la revendication 1, caractérisé en ce que le métal est un métal de transition.

3. Procédé suivant la revendication 1, caractérisé en ce que le métal est le chrome ou un alliage de chrome.

4. Procédé suivant l'une quelconque des revendications 1 à 3, caractérisé en ce que le bombardement est effectué pendant que le métal est déposé.

5. Procédé suivant l'une quelconque des revendications 1 à 3, caractérisé en ce que le bombardement est effectué après le dépôt.

6. Procédé suivant la revendication 5, caractérisé en ce que le dépôt et le bombardement sont effectués en créant un mouvement relatif entre le substrat et un premier endroit contenant le métal à une haute densité de vapeur, ainsi qu'un deuxième endroit contenant les ions énergétiques de telle sorte que le substrat soit successivement exposé à la haute densité de vapeur et aux ions énergétiques.

7. Procédé suivant la revendication 6, caractérisé en ce qu'on fait avancer le substrat à travers le premier et le deuxième endroit.

8. Procédé suivant l'une quelconque des revendications 1 à 7, caractérisé en ce que le substrat est constitué d'une matière plastique.

9. Procédé suivant l'une quelconque des revendications 1 à 8, caractérisé en ce que les ions sont des ions d'un gaz inerte.

10. Procédé suivant l'une quelconque des revendications 1 à 9, caractérisé en ce que les ions sont des ions d'un métal de transition.

11. Procédé suivant la revendication 10, caractérisé en ce que les ions sont des ions de chrome.

12. Procédé suivant l'une quelconque des revendications 1 à 11, caractérisé en ce que le métal est un métal ayant tendance à former un dépôt sous tension.

13. Procédé suivant l'une quelconque des revendications 1 à 12, caractérisé en ce que le dépôt est sous compression après le bombardement.

FIG. 1.

To Vacuum

To Vacuum

0 010 971

FIG. 2.

FIG. 3.

*Argon ions*

*3.4 keV ions, 60° substrates*

*11.5 keV ions, hot substrates*

*11.5 keV ions, 60° substrates*

*3.4 keV ions, hot substrates*

*Compression Stress (GN/m²) Tension*

*Dose (% ions/atom)*

FIG. 4.